(19) Europäisches Patentamt / European Patent Office / Office européen des brevets

(11) **EP 4 235 484 A1**

(12) **EUROPEAN PATENT APPLICATION**
published in accordance with Art. 153(4) EPC

(43) Date of publication:
**30.08.2023 Bulletin 2023/35**

(21) Application number: **21882159.3**

(22) Date of filing: **22.10.2021**

(51) International Patent Classification (IPC):
**G06F 40/146** (2020.01)

(52) Cooperative Patent Classification (CPC):
**G06F 40/146**

(86) International application number:
**PCT/CN2021/125766**

(87) International publication number:
**WO 2022/083747 (28.04.2022 Gazette 2022/17)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **23.10.2020 CN 202011145450**

(71) Applicant: **Amlogic (Shanghai) Co., Ltd.
Shanghai 201203 (CN)**

(72) Inventors:
• **ZENG, Tao
Shanghai 201203 (CN)**
• **PAN, Jianxin
Shanghai 201203 (CN)**

(74) Representative: **Maiwald GmbH
Engineering
Elisenhof
Elisenstrasse 3
80335 München (DE)**

(54) **TEXT COMPRESSION METHOD, MODULE, CHIP, ELECTRONIC DEVICE, AND STORAGE MEDIUM**

(57) The present disclosure relates to a text compression method, module, chip, electronic device and storage medium, wherein the method comprises: performing word segmentation processing on texts to be compressed, and collecting statistics about word length and word frequency of the words obtained after the word segmentation processing to construct a corresponding keyword list; compressing the texts to be compressed based on the constructed keyword list. The above scheme is beneficial to improve the compression ratio of text compression.

FIG.1

## Description

## TECHNICAL FIELD

The present disclosure relates to the technical field of computer, and in particular, to a text compression method, module, chip, electronic device and a storage medium.

## BACKGROUND

Text compression is to encode a large amount of text data according to a certain method to achieve the purpose of information compression and storage, and the compressed data can be restored to the state before compression through decoding without losing information.

However, the present text compression methods have the problem of a low compression ratio.

## SUMMARY

Some embodiments of the present disclosure provide a text compression method, module, chip, electronic device and a storage medium, to improve the compression ratio of text compression.

In some embodiments, a text compression method comprising: performing word segmentation processing on texts to be compressed, and collecting statistics about word length and word frequency of the words obtained after the word segmentation processing to construct a corresponding keyword list; and compressing the texts to be compressed based on the constructed keyword list.

The technical solutions of embodiments of the present disclosure have the following advantages: the text compression method, module, chip, electronic device and storage medium provided by embodiments of the present disclosure, wherein the text compression method performs word segmentation processing on texts to be compressed and collects statistics about word length and word frequency of the words obtained after the word segmentation processing to construct a corresponding keyword list, and then compresses the texts to be compressed based on the constructed keyword list as word segmentation processing is performed on the texts to be compressed before compression, and then the words obtained after the word segmentation processing are encoded, the length of the compressed characters can be increased, the compression efficiency can be significantly improved.

In some embodiments, a text compression module comprising: a list constructing unit configured to perform word segmentation processing on texts to be compressed, and collect statistics about word length and word frequency of the words obtained after the word segmentation processing to construct a corresponding keyword list; and a first compression unit configured to compress the texts to be compressed based on the constructed keyword list.

In some embodiments, a chip comprising the text compression module provided by the embodiments of the present disclosure.

In some embodiments, the embodiments of the present disclosure also provide an electronic device, the electronic device comprises the chip provided by the embodiments of the present disclosure.

In some embodiments, a storage medium, wherein the storage medium stores at least one or more computer instructions, one or more computer instructions are executed to implement the text compression method provided by the embodiments of the present disclosure.

## BRIEF DESCRIPTION OF THE DRAWINGS

The accompanying drawings, which comprise a part of this specification, illustrate several embodiments and, together with the description, serve to explain the principles and features of the disclosed embodiments. In the drawings:

FIG. 1 shows a schematic flow diagram of a text compression method provided by an embodiment of the present disclosure.

FIG. 2 shows a schematic flow diagram of a method for constructing a keyword list in an embodiment of the present disclosure.

FIG. 3 shows a schematic diagram of a keyword singly linked list pointed to by a keyword pointer array in an embodiment of the present disclosure.

FIG. 4 shows a schematic flow diagram of a method for compressing the texts to be compressed based on the constructed keyword list in an embodiment of the present disclosure.

FIG. 5 shows a schematic flow diagram of a method for constructing an adjacency merged red-black tree corresponding to each of the key words of the corresponding type in an embodiment of the present disclosure.

FIG. 6 shows a schematic diagram of the adjacency merged red-black tree of the keyword "call_" of the corresponding type constructed by an embodiment of the present disclosure.

FIG. 7 shows a schematic flow diagram of a method for performing merged encoding on key words of corresponding type in the first compressed text in an embodiment of the present disclosure.

FIG. 8 shows a schematic flow diagram of a method for compressing the ASCII code values in the third compressed text in the embodiment of the present disclosure.

FIG. 9 shows a schematic flow diagram of a method for constructing a two-dimensional array token_profit and counting the number of occurrences of uncoded characters in the third compressed text in an embodiment of the present disclosure.

**FIG. 10** shows a schematic diagram of the two-dimensional array token_profit constructed by the embodiment of the present disclosure.

**FIG. 11** shows a schematic diagram of the encoding slots of the two-dimensional array best_table constructed by an embodiment of the present disclosure.

**FIG. 12** shows a flow diagram of a method for allocating the remaining encoding slots in the two-dimensional array best_table to consecutive characters that appear multiple times in the third compressed text in an embodiment of the present disclosure.

**FIG. 13** shows a schematic block diagram of a text compression module in an embodiment of the present disclosure.

**FIG. 14** shows a schematic structural diagram of an optional hardware structure of the electronic device provided by the embodiment of the present disclosure.

## DETAILED DESCRIPTION

It can be known from the background that the present text compression methods have the problem of a low compression ratio.

Specifically, a present text compression method uses one encoding slot to compress one character or two characters or three characters, since the length of the compressed characters is relatively short, there is a problem of a low compression ratio.

To solve the above problems, the embodiments of the present disclosure provide a text compression method, first performing word segmentation processing on texts to be compressed, and collecting statistics about word length and word frequency of the words obtained after the word segmentation processing to construct a corresponding keyword list, and compressing the texts to be compressed based on the constructed keyword list, as word segmentation processing is performed on the texts to be compressed before compression, and then the words obtained after the word segmentation processing are encoded, the length of the compressed characters can be increased, the compression efficiency can be significantly improved

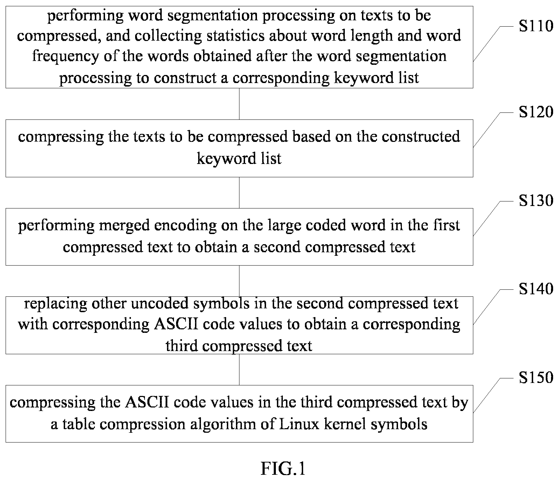

FIG. 1 shows a flow diagram of a text compression method provided by an embodiment of the present disclosure. Referring to FIG.1, a text compression method can specifically comprise: step S110: performing word segmentation processing on texts to be compressed, and collecting statistics about word length and word frequency of the words obtained after the word segmentation processing to construct a corresponding keyword list; and step S120: compressing the texts to be compressed based on the constructed keyword list.

To make the above purposes, features, and advantages of the present disclosure more apparent and easier to understand, a detailed description of specific embodiments of the present disclosure will be given below in conjunction with the accompanying drawings.

Performing step S110, performing word segmentation processing on texts to be compressed, and collecting statistics about word length and word frequency of the words obtained after the word segmentation processing to construct a corresponding keyword list.

In fact, for symbols in the Linux kernel code, there is a lot of duplication. After observation, it can be found that the symbols of the Linux kernel code have specific word segmentation symbols, that is, delimiters. According to this characteristic that the symbols of Linux kernel code have, in one embodiment of the present disclosure, when the texts to be compressed is Linux kernel code, the texts to be compressed can be divided into a plurality of corresponding words by delimiters. Wherein, the delimiters can be "-", "_" or spaces, etc.

Performing compression processing on the texts to be compressed provides a basis for the subsequent allocation of the word after word segmentation to corresponding encoding slots.

In an embodiment of the present disclosure, while word segmentation processing is performed on the texts to be compressed, based on a preset keyword data structure and a keyword pointer array, collecting statistics about word length and word frequency of the words obtained after the word segmentation processing to construct a corresponding keyword list to improve compression efficiency.

Specifically, in an embodiment of the present disclosure, the keyword data structure comprises the following elements: a next member configured to point to a hash singly linked list pointer of a next word with the same hash value; a word member configured to record a corresponding word; a total_cnt member configured to record the number of occurrences of the corresponding word; a word_len member configured to record a symbol length of the corresponding word in the word member; and an idx_type member configured to store a coded value of the corresponding word recorded in the word member.

Wherein, the next member is convenient for searching the storage location of the word, the setting of the word member is configured to record the information of the word described in the corresponding keyword data structure, and the total_cnt member can count the occurrence times of the words recorded in the word member, the word_len member is configured to record the character length of the word recorded in the word member, and the idx_type member is configured to allocate the encoding slot for the word recorded in the word member.

Using the keyword data structure to describe the words obtained after word segmentation can facilitate the word length and word frequency statistics of the words divided in the texts to be compressed, and then facilitate the subsequent allocation of corresponding encoding slots for the divided words.

In a specific implementation, the keyword pointer array is configured to store the keyword data structure instance of the divided words into a preset hash linked list space. Specifically, each member in the keyword pointer array has a corresponding pointer head, which points to a keyword singly linked list corresponding to the hash value, and each word in the keyword singly linked list has a pointer pointing to a next pointer to terms with the same hash value.

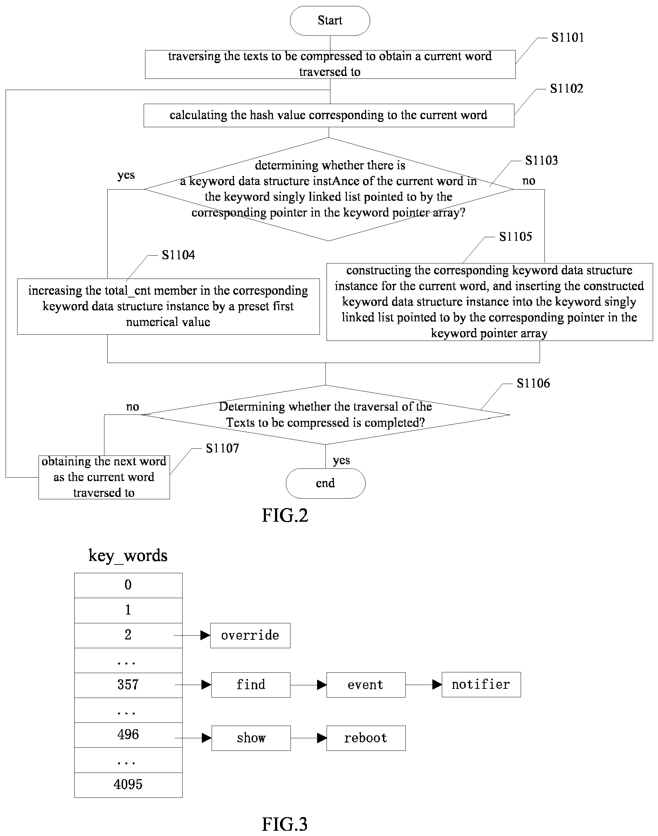

After the corresponding keyword data structure and keyword pointer array are set, based on a preset keyword data structure and a keyword pointer array, collecting statistics about word length and word frequency of the words obtained after the word segmentation processing to construct a corresponding keyword list, see FIG. 2 for details.

FIG. 2 shows a schematic flow diagram of a method for constructing a keyword list in an embodiment of the present disclosure. Referring to FIG. 2, a method for constructing a keyword list may specifically include the following steps:

Step S 1101: traversing the texts to be compressed to obtain a current word traversed to.

In a specific implementation, the texts to be compressed may be traversed in order, and words in the texts to be compressed may be identified with a delimiter as a boundary.

Traversing the words to be divided in the compressed text to facilitate the length and occurrences statistics of the words in the texts to be compressed.

Step S1102: calculating the hash value corresponding to the current word.

As mentioned above, the hash value of the word is used as the index of the keyword pointer array, and the hash linked list space is subsequently addressed through the index to find the keyword data structure instance corresponding to the word.

In a specific implementation, different hash functions can be used to calculate the hash value of words, and those skilled in the art can set it according to actual needs, which is not limited here.

Step S1103: with the calculated hash value as an index, determining whether there is a keyword data structure instance of the current word in the keyword singly linked list pointed to by the corresponding pointer in the keyword pointer array; in response to a determination of yes, performing step S 1104; otherwise, performing step S 1105.

In a specific implementation, the calculated hash value is the pointer head in the keyword pointer array, through which the corresponding keyword singly linked list can be found, subsequently, the current word can be compared one by one with the word member of each keyword data structure instance in the searched keyword singly linked list to determine whether the keyword data structure instance of the current word exists in the corresponding keyword singly linked list.

Referring to FIG. 3, for each word divided in the texts to be compressed, the keyword data structure instances of words with the same hash value are stored in the same keyword linked list.

For example, assuming that the word "override" has a hash value of 2 after hash calculation, then the keyword data structure instance of the word "override" will be inserted into the keyword singly linked list formed by the second pointer in the keyword pointer array. For the words "find", "event", and "notifier", the three have the same hash value 357, and they are all inserted into the keyword singly linked list pointed to by the pointer 357. When a word with a hash value of 357 appears later, it only needs to be compared with the words on the keyword singly linked list pointed to by the pointer 357 one by one.

Therefore, by using the array of keyword pointers, when storing the keyword data structure instance of the word in the texts to be compressed, the comparison between the words can be limited to the corresponding keyword singly linked list range, rather than compared with all the words already stored, thus the number of word query comparisons can be significantly reduced, and the compression efficiency can be improved.

Step S1104: increasing the total_cnt member in the corresponding keyword data structure instance by a preset first numerical value.

In a specific implementation, in response to a determination that the keyword data structure instance of the current word exists in the keyword singly linked list pointed to by the corresponding pointer in the keyword pointer array, increase the total_cnt member in the corresponding keyword data structure instance by a preset first numerical value to accumulate the number of occurrences of the current word in the texts to be compressed. Wherein, the first numerical value can be set according to actual needs, and no limitation is set here.

Step S1105: constructing the corresponding keyword data structure instance for the current word, and inserting the constructed keyword data structure instance into the keyword singly linked list pointed to by the corresponding pointer in the keyword pointer array.

In a specific implementation, when the keyword data structure instance of the current word does not exist in the keyword singly linked list pointed to by the corresponding pointer in the keyword pointer array, constructing the corresponding keyword data structure instance for the current word, and inserting the constructed keyword data structure instance into the keyword singly linked list pointed to by the corresponding pointer in the keyword pointer array to accumulate the number of occurrences of the current word. Specifically, in the constructed keyword data structure instance of the current word, the numerical value of the total_cnt member is the first numerical value, that is, when the keyword data structure instance is initialized, the numerical value of the total_cnt member is the first numerical value, and when the subsequent current word appears again, it is accumulated based on the first numerical value, thus the number of occurrences of the current word in the texts to be compressed can be cumulatively counted.

Step S1106: determining whether the traversal of the texts to be compressed is completed; end the operation in response to a determination of yes; otherwise, step S1107 may be executed.

Step S1107: obtaining the next word as the current word traversed to, and restarting execution from step S 1102.

In a specific implementation, when the traversal of the words in the texts to be compressed is not completed, obtaining the next word based on the delimiter, taking the obtained next word as the current word traversed to, and restarting execution from step S1102 until the traversal of all the words in the texts to be compressed is completed, then the keyword list corresponding to the texts to be compressed can be obtained.

However, in practical applications, for the words obtained after word segmentation, not every word has a compression value. For example, when the length of the divided words is less than or equal to the length of the compression code, or the number of occurrences of the words is relatively small, compressing and encoding this type of words will not only fail to achieve the purpose of saving storage space but also cause a further reduction in compression efficiency.

For this reason, in one embodiment of the present disclosure, filtering the words that do not meet the compression conditions in the constructed keyword list by setting the corresponding encoding conditions to further improve the compression efficiency.

Specifically, the encoding conditions are:

$$n \times L > (2 + L) \quad (1)$$

Wherein, n indicates the occurrence frequency of the word, L indicates the symbol length of the word.

By setting the above encoding conditions, words that appear less often or whose length is shorter than a preset encoding length can be deleted from the constructed keyword list to improve compression efficiency. Specifically, by traversing all the keyword singly linked lists pointed to by the pointers in the keyword pointer array, query the keyword data structure instance that does not meet the above encoding conditions, and delete it from the corresponding keyword singly linked list.

Executing the above steps S 1101 to S 1107, the corresponding keyword data structure instance can be constructed for the words obtained after word segmentation in the texts to be compressed, and stored in the keyword singly linked list pointed to by the keyword pointer array, to obtain the information of the number of occurrences of the words by querying the keyword data structure instance of the words subsequently, and compress the words based on the information of the number of occurrences of the words obtained.

Performing step S120, compressing the texts to be compressed based on the constructed keyword list.

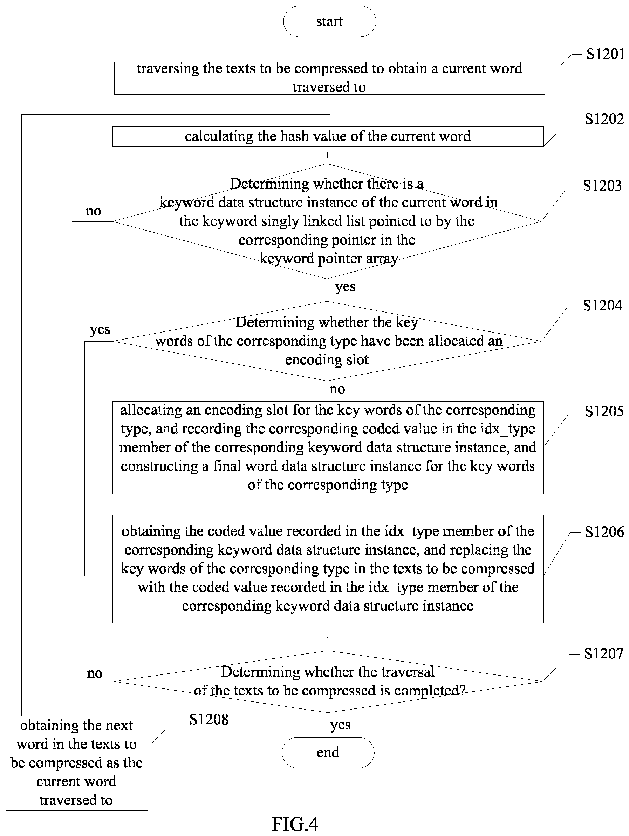

As mentioned earlier, in the constructed keyword list, that is, the keyword data structure instance of the words stored in the hash linked list space, the information of the words and their occurrence times in the texts to be compressed is recorded. Therefore, based on the constructed keyword list, information on the words and their occurrence times in the texts to be compressed can be obtained, and then the words in the texts to be compressed can be compressed and encoded based on the information on the number of occurrences of the words, please refer to FIG. 4 for details.

FIG. 4 shows a schematic flow diagram of a method for compressing the texts to be compressed based on the constructed keyword list in an embodiment of the present disclosure. Referring to FIG. 4, a method for compressing the texts to be compressed based on the constructed keyword list in an embodiment of the present disclosure may specifically comprise:

Step S1201: traversing the texts to be compressed to obtain a current word traversed to.

In a specific implementation, the texts to be compressed are traversed, so that subsequently the words appearing in the texts to be compressed are allocated corresponding encoding slots according to the keyword data structure instance stored in the keyword list.

Step S 1202: calculating the hash value of the current word.

In a specific implementation, the hash function used to calculate the hash value of the current word is the same as the hash function used for constructing the keyword list.

Step S1203: with the calculated hash value as an index, determining whether there is a keyword data structure instance of the current word in the keyword singly linked list pointed to by the corresponding pointer in the keyword pointer array; in response to a determination of yes, performing step S1204; otherwise, performing step S1206.

In a specific implementation, with the calculated hash value as an index, determining whether there is a keyword data structure instance of the current word in the keyword singly linked list pointed to by the corresponding pointer in the keyword pointer array provides a basis for subsequently allocating an encoding slot for the current word.

Step S1204: combining the current word traversed to with the delimiter at a corresponding position to form a key word of a corresponding type, and based on the numerical value of the idx_type member in the keyword data structure instance corresponding to the current word, determining whether the key words of the corresponding type have been allocated an encoding slot; in response to a determination of yes, performing step S1206; otherwise, performing step S1205.

In a specific implementation, when constructing the keyword list, it does not include the delimiter information in the texts to be compressed. In actual compression, the delimiter can be combined with one of the words that appear before and after it to further improve the compression ratio and facilitate the subsequent operation of merging words.

Specifically, according to the positional relationship between the delimiter and the word, the delimiter and the words that appear before and after it are combined to obtain the following four corresponding types of key words:

a first type of key word, including the corresponding word and the delimiter after the word;
a second type of key word, including the corresponding delimiter and the word after the delimiter;
a third type of key word, including the corresponding word and the delimiters before and after the word; and
a fourth type of key word, including only the corresponding word.

Specifically, when a word in the keyword list appears at the beginning of a symbol, or the previous word has been merged with the delimiter before the word, the word can be merged with the delimiter that appears behind it to form the first type of keywords; when a word in the keyword list appears at the end of a symbol and the previous word has no compression value, the word is merged with the delimiter that appears before it to form the second type of keywords; the words before and after the word in the keyword list are all words that do not have compression values, then the words can be merged with the delimiters that appear before and after it to form the third type of keywords; the word in the keyword list appears at the end of the symbol and the previous word is a word with compression value, and the delimiter before the word has been merged with the word before the current word, then the word itself constitutes the fourth type of key word.

After the current word traversed to and the delimiters that appear before and after it are merged to form key words of a corresponding type among the above four types, allocating the encoding slot for the key words of the corresponding type merged.

As mentioned earlier, in the key data structure instance, the idx_type member is configured to record a coded value of the corresponding word. At the time of initialization, the idx_type member is set to a default value; when the corresponding word has been allocated an encoding slot, the idx_type member is the information of the allocated encoding slot.

Therefore, when there is a keyword data structure instance of the current word traversed to in the keyword singly linked list pointed to by the corresponding pointer in the keyword pointer data, it can be determined whether the key words of the corresponding type have been allocated an encoding slot by querying the information recorded in the idx_type member.

Step S1205: allocating an encoding slot for the key words of the corresponding type, and recording the corresponding coded value in the idx_type member of the corresponding keyword data structure instance, and constructing a final word data structure instance for the key words of the corresponding type.

in response to a determination that the key words of the corresponding type have not been allocated an encoding slot and there is an idle encoding slot, allocating an encoding slot for the key words of the corresponding type, and recording the corresponding coded value in the idx_type member of the corresponding keyword data structure instance.

When allocating an encoding slot for the key words of the corresponding type, constructing a final word data structure instance for the key words of the corresponding type to record the encoding information of the key words of the corresponding type that is finally generated for subsequent query during decompression.

In an embodiment of the present disclosure, the final word data structure corresponding to the final word data structure instance includes the following elements:

a Str member configured to record the information of the key words of the corresponding type;
a Len member configured to record a character length of the key words of the corresponding type; and
a cnt member configured to record the number of occurrences of the key words of the corresponding type.

It should be noted that other methods can also be used to record the finally generated information of the key words of the corresponding type, which those skilled in the art can choose according to actual needs, and the present disclosure does not limit it here.

Step S1206: obtaining the coded value recorded in the idx_type member of the corresponding keyword data structure instance, and replacing the key words of the corresponding type in the texts to be compressed with the coded value recorded in the idx_type member of the corresponding keyword data structure instance.

In a specific implementation, in response to a determination that the key words of the corresponding type have been allocated an encoding slot, obtaining the coded value recorded in the idx_type member of the corresponding keyword data structure instance, and replacing the key words of the corresponding type in the texts to be compressed with the coded value recorded in the idx_type member of the corresponding keyword data structure instance, thereby compressing the key words of the corresponding type appearing in the texts to be compressed.

Step S1207: determining whether the traversal of the texts to be compressed is completed; end the operation in response to a determination of yes; otherwise, step S1208 may be executed.

Step S1208: obtaining the next word in the texts to be compressed as the current word traversed to, and restarting execution from step S1202.

In a specific implementation, when the traversal of the words in the texts to be compressed is not completed, obtaining the next word as the current word traversed to, and restarting execution from step S 1202 until the traversal of all the words in the texts to be compressed is completed to obtain a first compressed text.

In the embodiments provided by the present disclosure, regarding the character string appearing in the unit of line in the Linux kernel code symbol as one symbol. Through observation, it can be found that each symbol contains multiple words, and the included words have the same arrangement order, as shown below:

```
00000000 t trace_event_raw_event_timer_class
00000000 t trace_event_raw_event_timer_start
00000000                                    t
trace_event_raw_event_timer_expire_entry
00000000 t trace_event_raw_event_hrtimer_init
00000000 t trace_event_raw_event_hrtimer_start
00000000                                    t
trace_event_raw_event_hrtimer_expire_entry
00000000 t trace_event_raw_event_hrtimer_class
00000000 t trace_event_raw_event_itimer_state
```

As shown above, multiple symbols are starting with "trace_event_raw_event_". Therefore, in the embodiment of the present disclosure, the compression ratio is further improved by performing merged encoding on multiple words that appear multiple times in the texts to be compressed and appear in order.

Specifically, please continue to refer to FIG. 1, after obtaining the first compressed text is obtained, it may also include:

Step S130: performing merged encoding on the large coded word in the first compressed text to obtain a second compressed text.

In an embodiment of the present disclosure, constructing an adjacency merged red-black tree for each of the large coded words appearing in the first compressed text, and performing merged encoding on the large coded word in the first compressed text.

To facilitate the construction of the adjacency merged red-black tree of each large coded words, the aforementioned final word data structure instance constructed for the key words of the corresponding type also includes the following member:

a node_cnt member configured to record the number of key words of different corresponding types adjacent to the corresponding type of the key word.

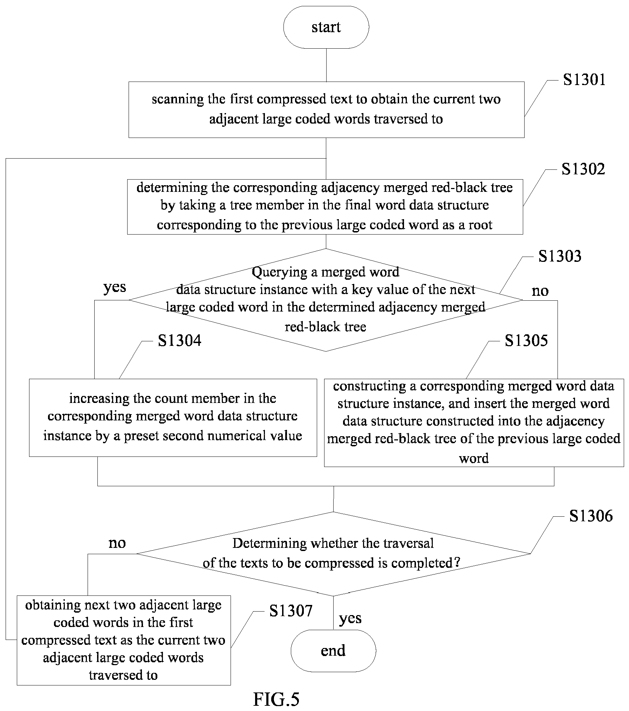

Specifically, constructing the adjacency merged red-black tree of key words of the corresponding type using a preset merged word data structure, to collect statistics about the words of the other corresponding types adjacent to the key words of corresponding type and their occurrence numbers, please refer to FIG. 5 for details.

Wherein, in an embodiment of the present disclosure, the merged word data structure includes the following members:

an entry member configured to represent a root node of the adjacency merged red-black tree;

a code member configured to record the coded value of the key word of the corresponding type adjacent to the root node of the adjacency merged red-black tree recorded in the entry member;

a count member configured to record the number of occurrences of the key word of corresponding type adjacent to the root node of the adjacency merged red-black tree recorded in the entry number.

FIG. 5 shows a schematic flow diagram of a method for constructing an adjacency merged red-black tree of each large coded word in an embodiment of the present disclosure. Referring to FIG. 5, a method for constructing an adjacency merged red-black tree of each large coded word may specifically include:

Step S1301: scanning the first compressed text to obtain the current two adjacent large coded words traversed to.

In a specific implementation, the first compressed text is obtained by compressing the key words of corresponding type in the texts to be compressed, that is, the first compressed text includes information about the encoding of the key words of corresponding type and other uncoded characters. For ease of description, in the embodiments of the present disclosure, the coded value corresponding to the key word of corresponding type is called a large coded word.

The inventors of the present disclosure have found through research that when consecutive large coded words appear in the first compressed text and the number of occurrences of the consecutive large coded words is greater than or equal to a preset merged threshold, performing merging on the consecutive large coded words, which can further improve the compression ratio. For this reason, the first compressed text can be scanned in an order from front to back to query whether there are two adjacent large coded words in the first compressed text, which provides a basis for the subsequently merged encoding of two adjacent large coded words obtained from the query.

Step S1302: determining the corresponding adjacency merged red-black tree by taking a tree member in the final word data structure corresponding to the previous large coded word as a root.

In a specific implementation, in response to a determination that there are two adjacent large coded words in the first compressed text, in the current two adjacent large coded words traversed to, regrading a large coded word arranged in front as the previous large coded words, and regarding a large coded word arranged after as the next large coded word, querying the tree member in the final word data structure corresponding to the previous large coded words, and with the tree member as the root, the corresponding adjacency merged red-black tree can be queried and obtained.

Step S1303: querying a merged word data structure instance with a key value of the next large coded word in the determined adjacency merged red-black tree; in response to a determination that there is a corresponding merged word data structure instance, performing step S1304; otherwise, performing step S1305.

In a specific implementation, each node in the adjacency merged red-black tree obtained by the query includes the key value information of the key word of the corresponding type adjacent to the key word of the corresponding type. Therefore, by querying whether there is a merged word data structure instance with a key value of the next large coded word in the determined adjacency merged red-black tree, to determine whether the merged word data structure instance of the next big coded word exists in the adjacency merged red-black tree of the previous big coded word, which facilitates subsequent statistics of the occurrences number of the two adjacent large coded words in the first compressed text.

Step S1304: increasing the count member in the corresponding merged word data structure instance by a preset second numerical value.

In a specific implementation, when the merged word data structure instance with a key value of the next large coded word exists in the determined adjacency merged red-black tree, it indicates that the current two adjacent large coded words have appeared before. At this time, the count member in the corresponding merged word data structure instance can be increased by a preset second numerical value to accumulate the number of occurrences of the two adjacent large coded words. Wherein, the second value can be set according to actual needs, and no limitation is set here.

Step S1305: constructing a corresponding merged word data structure instance, and insert the merged word data structure constructed into the adjacency merged red-black tree of the previous large coded word.

In a specific implementation, when there isn't a corresponding merged word data structure instance in the determined adjacency merged red-black tree, constructing a corresponding merged word data structure instance and inserting it into the adjacency merged red-black tree of the previous large coded word to count the number of occurrences of the current two adjacent large coded words traversed to appearing in the first compressed text.

In the constructed corresponding merge word data structure instance, that is, at the time of initialization, the entry member is the value of the node of the allocated adjacency merged red-black tree, the code member is the coded value of the next large coded word, and the numerical value of the count member can be a default initial value. When the current two adjacent large coded words traversed to appear again later, the number of occurrences of the current two adjacent large coded words traversed to can be counted by accumulatively counting the numerical value of the count member.

Step S1306: determining whether the traversal of the texts to be compressed is completed; end the operation in response to a determination of yes; otherwise, step S1307 may be executed.

Step S1307: obtaining next two adjacent large coded words in the first compressed text as the current two adjacent large coded words traversed to, and restarting execution from step S1302.

In a specific implementation, when the traversal of the first compression text has not been completed, taking the next two adjacent large coded words as the current two adjacent large coded words traversed to, and restarting execution from step S1302 to count the number of occurrences of adjacent large coded words that appear in the first compressed text until the traversal of the first compressed text is completed.

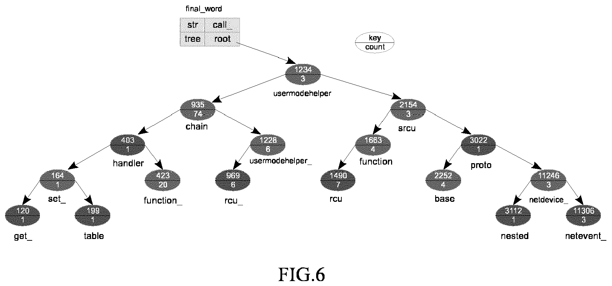

Please refer to Fig. 6, taking the previous large coded word is "call_" as an example, querying a final word data structure instance whose Str member is "call_" in the final word data structure. When the final word data structure instance whose Str member is "call_" is queried, the numerical value of the tree member is queried from the final word data structure instance of "call_", and with the tree member in the final word data structure instance corresponding to "call_" as the root, the adjacency merged red-black tree of "call_" can be queried and obtained. Table 1 shows the information of the adjacency merged red-black tree of "call_".

Table 1

| key | count | first string -> next string |
|---|---|---|
| 120 | 1 | call_ -> get_ |
| 164 | 1 | call_ -> set_ |
| 199 | 1 | call_ -> table |
| 403 | 1 | call_ -> handler |
| 423 | 20 | call_ -> function_ |
| 935 | 74 | call_ -> chain |
| 969 | 6 | call_ ->rcu_ |
| 1228 | 6 | call_ ->usermodehelper_ |
| 1234 | 3 | call_ ->usermodehelper |
| 1663 | 4 | call_ -> function |
| 2154 | 3 | cal_ ->srcu |
| 2252 | 4 | call_ -> base |
| 3022 | 1 | call_ -> proto |
| 3112 | 1 | call_ -> nested |
| 11246 | 3 | cal_ ->netdevice_ |
| 11306 | 3 | cal_ ->netevent_ |

As shown in Table 1, "call_" has 16 kinds of adjacent words. Wherein, the adjacent word "function_" appeared 20 times after "call_", and "chain" appeared 74 times after "call_", all of which have compression values, while the word "nested" appeared only once after "call_".

It should be noted that the depth of the adjacency merged red-black tree for each corresponding type of key words is different. For example, an adjacency merged red-black tree for words like "get", "set", and "put", can have as many as thousands of nodes.

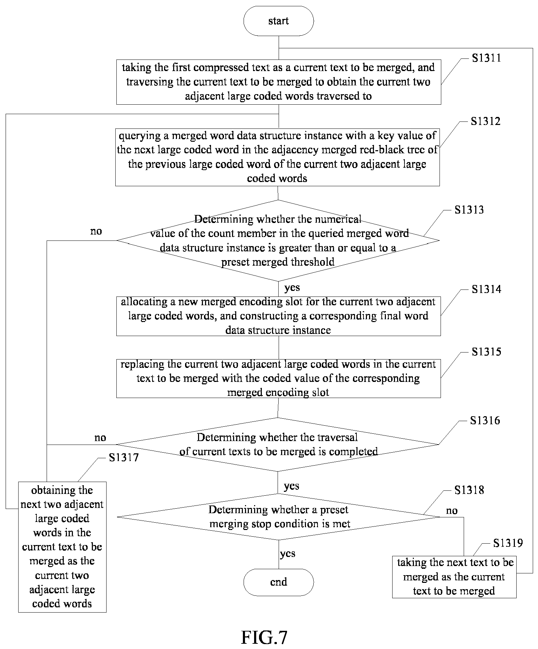

Performing the above-mentioned steps S1301 to S1307, after constructing the corresponding adjacency merge red-black tree for the two adjacent large coded words in the first compressed text, the adjacency large coded words in the first compressed text can be merged according to the constructed adjacency merged tree, please refer to FIG. 7 for details.

FIG. 7 shows a schematic flow diagram of a method for performing merged encoding on key words of the corresponding type in the first compressed text in an embodiment of the present disclosure. Referring to FIG. 7, a method for performing merged encoding on key words of the corresponding type according to the constructed adjacency merged red-black tree may specifically include the following steps:
Step S1311: taking the first compressed text as a current text to be merged, and traversing the current text to be merged to obtain the current two adjacent large coded words traversed to.

In a specific implementation, taking the first compressed text as a current text to be merged, and traversing the current text to be merged to obtain the adjacency merged red-black tree of the previous large coded word in the two adjacent large coded words that appear in the first compressed text.

It should be noted that, when performing the first round of merged encoding, the current text to be merged is the first compressed text; after performing the first round of merged encoding, that is, starting from the second round of merged encoding, the subsequent current text to be merged is the text obtained after the last round of merged encoding.

In a specific implementation, the symbols in the current text to be merged can be traversed in order from front to back to query two adjacent large coded words that appear.

Step S1312: querying a merged word data structure instance with a key value of the next large coded word in the adjacency merged red-black tree of the previous large coded word of the current two adjacent large coded words.

As mentioned above, in each red-black tree node of the adjacency merged red-black tree of the key word of the corresponding type, the information of the key words of other corresponding types adjacent to the key word of the corresponding type and the number of occurrences thereof is respectively recorded. Therefore, in the adjacency merged red-black tree of the key words of the corresponding type, querying the merged word data structure instance whose key value is the next large coded word, to obtain the information of the number of occurrences recorded in the count member of the merged word data structure instance, to determine whether to perform merged encoding according to the information of the number of occurrences recorded in the count member in subsequent steps.

Step S1313: determining whether the numerical value of the count member in the queried merged word data structure instance is greater than or equal to a preset merged threshold; performing step S1314 in response to a determination of yes; otherwise, performing step S1316.

In a specific implementation, comparing the numerical value of the count member in the merged word data structure instance with the preset merged threshold to determine whether the currently traversed two adjacent large coded words have the value of merged encoding, to further improve the compression ratio. Wherein, the merged threshold can be set according to actual needs, and no limitation is set here.

Step S1314: allocating a new merged encoding slot for the current two adjacent large coded words, and constructing a corresponding final word data structure instance.

In a specific implementation, in response to a determination that the numerical value of the count member in the queried merged word data structure instance is greater than or equal to a preset merged threshold, allocating a new merged encoding slot for the current two adjacent large coded words, to merge the original two coded values with a fixed length into one coded value with the fixed length to further improve compression ratio.

While allocating a new merged encoding slot for the current two adjacent large coded words, and constructing a corresponding final word data structure instance for the current two adjacent large coded words, to record the merged encoding information of the two adjacent large coded words for subsequent decompression

Step S1315: replacing the current two adjacent large coded words in the current text to be merged with the coded value of the corresponding merged encoding slot.

In a specific implementation, after allocating the corresponding merged encoding slot for the current two adjacent large coded words, replacing the current two adjacent large coded words in the current text to be merged with the coded value of the corresponding merged encoding slot, to realize further compression of the current text to be merged.

Step S1316: determining whether the traversal of current texts to be merged is completed; performing step S1318 in response to a determination of yes; otherwise, performing step S1317.

Step S1317: obtaining the next two adjacent large coded words in the current text to be merged as the current two adjacent large coded words, and restarting execution from step S1312.

In a specific implementation, when the traversal of the current text to be merged has not been completed, obtaining the next two adjacent large coded words in the current text to be merged as the current two adjacent large coded words, and restarting execution from step S1312 until the traversal of the current text to be merged is completed, a round of merged encoding operations for large coded words is completed.

Step S1318: determining whether a preset merging stop condition is met; the operation can be ended in response to a determination of yes; otherwise, step S1319 can be executed.

In a specific implementation, the number of words included in the words that appear multiple times in the same order in the text to be compressed may be greater than two, for which the above-mentioned operation of merging words can be performed for multiple rounds.

Specifically, taking the character string "trace_event_raw_event_" appearing in the text to be compressed as an example, when performing a round of merged encoding on the current text to be merged, merge "trace _" and "event_" in it; after that, another round of merging is performed to merge the merged "trace_event_" with the subsequent "raw_"; then, continue to perform the next round of merging to merge the merged "trace_event_raw_" with the subsequent "event_". In this way, multiple rounds of the above-mentioned merged encoding operations are performed to further improve the compression ratio.

Theoretically, the number of rounds for merging words, that is, the threshold for the number of merging rounds should not exceed the maximum number of words included in one symbol in the texts to be compressed. Wherein, the maximum number of words included in one symbol in the texts to be compressed can be obtained during the operation of constructing the keyword list.

In addition, when performing merged encoding on the key words of the corresponding types, it is necessary to allocate new encoding slots for multiple words after merging. Therefore, when the encoding slots are full, that is, when the encoding slots have been allocated, the merging cannot continue.

Therefore, the merging stop condition set in the embodiment of the present disclosure is any one of the following three items:

    (1) the number of merging rounds is greater than a corresponding round threshold;
    (2) all of the numerical values of the count member of the merged word data structure instance in the adjacency merged red-black tree of the key words of the corresponding type in the first compressed text are less than the merged threshold; and
    (3) the encoding slots have been allocated.

Step S1319: taking the next text to be merged as the current text to be merged, and restarting from step S1311.

When any one of the above-mentioned merging stop conditions is met, the operation of performing merged encoding on the key words of the corresponding type can be stopped to obtain the second compressed text.

Please continue refer to FIG.1, for further improvement of the compression ratio, in an embodiment of the present disclosure, after obtaining the second compressed text, the method also includes:
Step S140, replacing other uncoded symbols in the second compressed text with corresponding ASCII code values to obtain a corresponding third compressed text.

In practical applications, after the above steps S110 to S140 processing, the words in the text to be compressed and the corresponding delimiters have been replaced by the corresponding large coded words, but there are still some uncompressed symbols.

Therefore, for further improvement of the compression ratio, the uncompressed symbols in the second compressed text can be replaced by the corresponding ASCII code values to obtain the corresponding third compressed text.

Please continue to refer to FIG. 1, to further improve the compression ratio, after obtaining the corresponding third compressed text, the method can also include:
Step S150: compressing the ASCII code values in the third compressed text by a table compression algorithm of Linux kernel symbols.

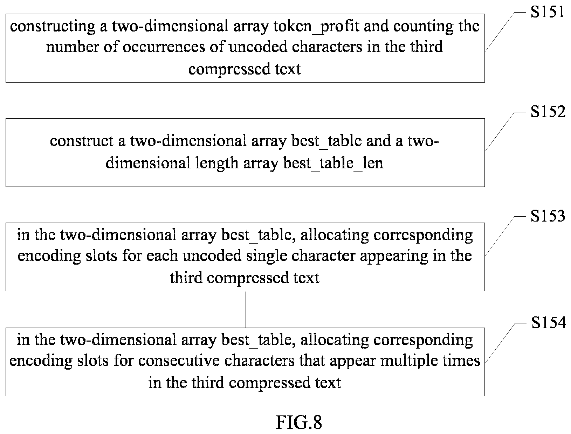

In the present disclosure, the ASCII code value corresponding to the uncompressed symbol is configured as a small coded word to distinguish from the aforementioned large coded words, and the Linux kernel symbol table compression algorithm is used to compress the remaining small coded words in the third compressed text to further improve the compression ratio, please refer to FIG. 8 for details.

FIG. 8 shows a schematic flow diagram of a method for compressing the ASCII code values in the third compressed text in the embodiment of the present disclosure. Referring to FIG. 8, a method for compressing the ASCII code values in the third compressed text may specifically include the following steps:
Step S151: constructing a two-dimensional array token_profit and counting the number of occurrences of uncoded characters in the third compressed text.

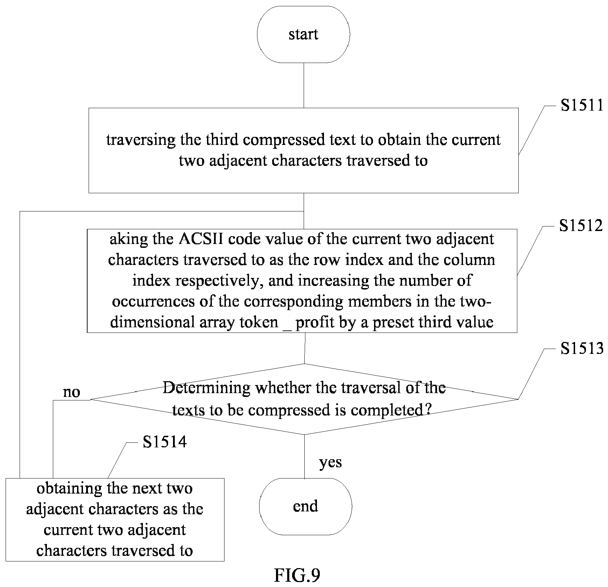

In an embodiment of the present disclosure, a method for constructing a two-dimensional array token_profit and counting the number of occurrences of uncoded characters in the third compressed text, as shown in FIG. 9.

Referring to FIG. 9, a method for constructing a two-dimensional array token_profit and counting the number of occurrences of uncoded characters in the third compressed text in the embodiment of the present disclosure may specifically include:

Step S1511: traversing the third compressed text to obtain the current two adjacent characters traversed to.

Step S1512: taking the ACSII code value of the current two adjacent characters traversed to as the row index and the column index respectively, and increasing the number of occurrences of the corresponding members in the two-dimensional array token_ profit by a preset third value.

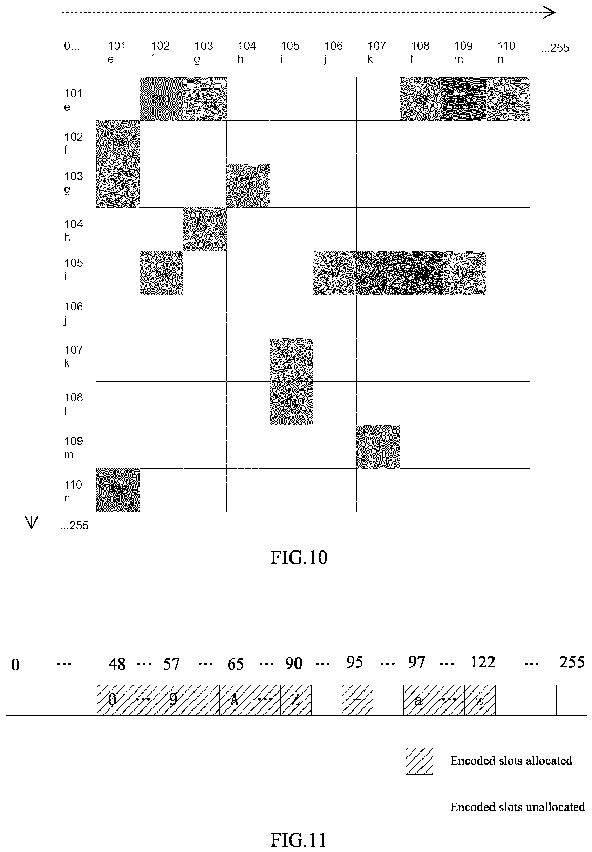

Referring to FIG. 10, in the two-dimensional array token _profit, the values in the horizontal and vertical axes represent the ASCII code values of the corresponding characters respectively, and the letters below the values in the horizontal and vertical axes represent the characters corresponding to the ACSII code values; the number of members in the two-dimensional array token _ profit represents the number of letter combinations of the horizontal and vertical axes, that is, the optimized value.

For example, the optimized value of the two consecutive characters 'le' represented by row 101 and column 108 is 83, indicating that the number of consecutive characters ' le ' is 83; the optimized value of the two consecutive characters ' ki' represented by row 105 and column 107 is 217, indicating that the two consecutive characters ' ki ' appear 217 times in the third compressed text. In addition, the blank square in the two-dimensional array token _ profit indicates that the corresponding character combination does not appear in the third compressed text.

Step S 1513: determining whether the traversal of the texts to be compressed is completed; end the operation in response to a determination of yes; otherwise, step S1514 may be executed.

Step S1514: obtaining the next two adjacent characters as the current two adjacent characters traversed to, and restarting execution from step S1512.

In a specific implementation, when it is determined that the traversal of the third compressed text has not been completed, obtain the next two adjacent characters from the third compressed text in order as the current two adjacent characters traversed to, and restart execution from step S1512 until all uncoded characters in the third compressed text have been traversed.

By executing the above steps S1511 to S1514, the number of occurrences of the consecutive characters that appear in the third compressed text can be recorded in the two-dimensional array token_profit, so that the number of occurrences of the continuous characters recorded in the two-dimensional array token_profit can be recorded subsequently, further compressing the small coded words in the third compressed text.

Performing step S152 to construct a two-dimensional array best_table and a two-dimensional length array best_table_len.

In a specific implementation, a two-dimensional array best table and a two-dimensional length array best_table_len are constructed to subsequently allocate encoding slots to uncoded characters in the third compressed text.

In the embodiment of the present disclosure, the two-dimensional array best_table is an unsigned character two-dimensional array, which is configured to record the information of the encoding slot and the two consecutive characters allocated to the encoding slot; the two-dimensional array best_table_len is configured to record the information of the encoding slot to be allocated.

It should be noted that the numerical values of the members in the two-dimensional array best_table_len can be divided into three types: the first type, when the number of characters corresponding to the encoding slot is 1, set the value of the member in the two-dimensional array best_table_len to a preset fourth value; the second type, when the number of characters corresponding to the encoding slot is 2, the value of the member in the two-dimensional array best_table_len is set to a preset fifth value; the third type, when the encoding slot has not been allocated, the values of the members in the two-dimensional array best_table_len are set to a preset sixth value. Therefore, through the information of the numerical values of the members in the two-dimensional array best_table_len, it can be determined whether the corresponding code has been allocated to the corresponding character, and it can be determined whether the character corresponding to the allocated encoding slot is a single character or a character string consisting of two characters.

Performing step S153, in the two-dimensional array best_table, allocating corresponding encoding slots for each uncoded single character appearing in the third compressed text.

In practical applications, after the two-dimensional array token_profit is constructed, the third compressed text is traversed again, taking the ASCII code value of the character appearing in the third compressed text as an index, assigning the corresponding encoding slot in the two-dimensional array best table to the corresponding character, and setting the numerical value of the corresponding member in the best_table_len array as the fourth value to indicate that the encoding slot is already occupied and the corresponding number of characters is 1.

Referring to FIG. 11, in practical applications, the characters included in the C language naming convention are "0"~"9", "A"-"Z", "a"-"z", according to the character "0" ~"9", "A"~"Z", ASCII code value of "a"-"z". In the two-dimensional array best table, according to the ASCII code value corresponding to each character in "0"~"9", "A"~"Z", "a"-"z", the corresponding characters in the two-dimensional array best_table, assign the corresponding coding slots in the two-dimensional array best_table respectively.

Performing step S154, in the two-dimensional array best_table, allocating corresponding encoding slots for consecutive characters that appear multiple times in the third compressed text.

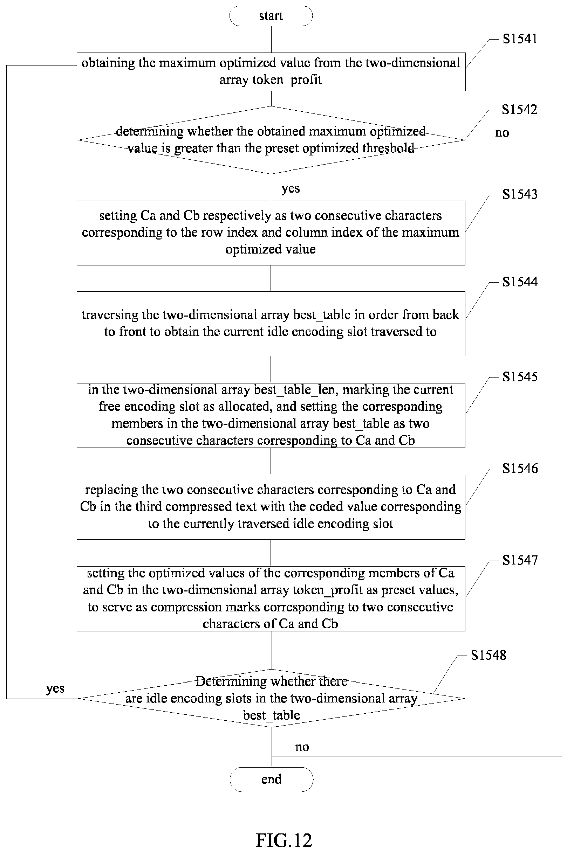

In a specific implementation, after step S163 is executed, the remaining encoding slots in the two-dimensional array best table can be allocated to consecutive characters that appear multiple times in the third compressed text, please refer to FIG. 12 for details.

FIG. 12 shows a flow diagram of a method for allocating the remaining encoding slots in the two-dimensional array best_table to consecutive characters that appear multiple times in the third compressed text in an embodiment of the present disclosure. Please refer to FIG. 12, a method for allocating the remaining encoding slots in the two-dimensional array best_table to consecutive characters that appear multiple times in the third compressed text may specifically comprise:

Step S1541: obtaining the maximum optimized value from the two-dimensional array token_profit.

In a specific implementation, the optimized value of the member in the two-dimensional array token_profit represents the number of occurrences of the corresponding two consecutive characters in the third compressed text. Therefore, the greater the optimized value in the two-dimensional array token_profit, the more the corresponding two characters appear, and preferentially assigning encoding slots to the two characters is beneficial to improve the compression ratio.

Step S1542: determining whether the obtained maximum optimized value is greater than the preset optimized threshold; when the determination is yes, step S1543 can be executed; otherwise, the operation can be ended.

In a specific implementation, the optimized threshold can be set according to actual needs, and no limitation is set here. It can be understood that when the encoding slots are sufficient, the greater the optimized threshold, the less the number of two characters that can be optimized; otherwise, the more the number of two characters that can be optimized.

Step S1543: setting Ca and Cb respectively as two consecutive characters corresponding to the row index and column index of the maximum optimized value.

In a specific implementation, Ca and Cb are configured to record the characters corresponding to the row index and column index of the maximum optimized value in the two-dimensional array token_profit.

Step S1544: traversing the two-dimensional array best_table in order from back to front to obtain the current idle encoding slot traversed to.

In practical applications, part of the encoding slots in the two-dimensional array best_table has been assigned to "0"~"9", "A"~"Z", "a"-"z", and they are "0"~"9", and for "A"-"Z", the encoding slots assigned by "a"-"z" are located in the front row of the two-dimensional array best table. In other words, the idle encoding slots in the two-dimensional array best_table_len are located at the end of the two-dimensional array best_table. Therefore, traversing the two-dimensional array best_table in reverse order from back to front is beneficial to quickly find idle encoding slots, thereby helping to further improve compression efficiency.

Step S1545: in the two-dimensional array best_table_len, marking the current free encoding slot as allocated, and setting the corresponding members in the two-dimensional array best_table as two consecutive characters corresponding to Ca and Cb.

In a specific implementation, by marking the current idle encoding slot as allocated in the two-dimensional array best_table_len, and setting the corresponding members in the two-dimensional array best_table as two consecutive characters corresponding to Ca and Cb, the corresponding encoding slots in the two-dimensional array best table can be allocated to two consecutive characters corresponding to Ca and Cb.

Step S1546: replacing the two consecutive characters corresponding to Ca and Cb in the third compressed text with the coded value corresponding to the currently traversed idle encoding slot.

In a specific implementation, after allocating the corresponding encoding slots for the two consecutive characters corresponding to Ca and Cb, the two consecutive characters corresponding to Ca and Cb in the third compressed text are replaced with the corresponding coded value of the current idle encoding slot, to compress the two consecutive characters corresponding to Ca and Cb in the third compressed text.

Step S 1547: setting the optimized values of the corresponding members of Ca and Cb in the two-dimensional array token_profit as preset values, to serve as compression marks corresponding to two consecutive characters of Ca and Cb.

In the specific implementation, after allocating the corresponding encoding slots for the two consecutive characters corresponding to the member with the maximum optimized value in the two-dimensional array token_profit, by setting the optimized value of this member to a preset value, specifically, reducing the optimized value of this member to the preset value, as a compression mark corresponding to two consecutive characters of Ca and Cb, to traverse the optimized values of the members in the two-dimensional array token_profit according to the order of optimized values from large to small.

Step S1548: determining whether there are idle encoding slots in the two-dimensional array best_table; step S1541 can be executed in response to a determination of yes; otherwise, the operation can be ended.

In a specific implementation, when there are idle encoding slots in the two-dimensional array best_table, the execution can be restarted from step S1542, to continue to allocate idle encoding slots for two consecutive characters corresponding to the members in the two-dimensional array token_profit; otherwise, the encoding slots in the two-dimensional array best_table_len have been exhausted, and the operation can be ended at this time.

Correspondingly, the embodiment of the present disclosure also provides a text compression module.

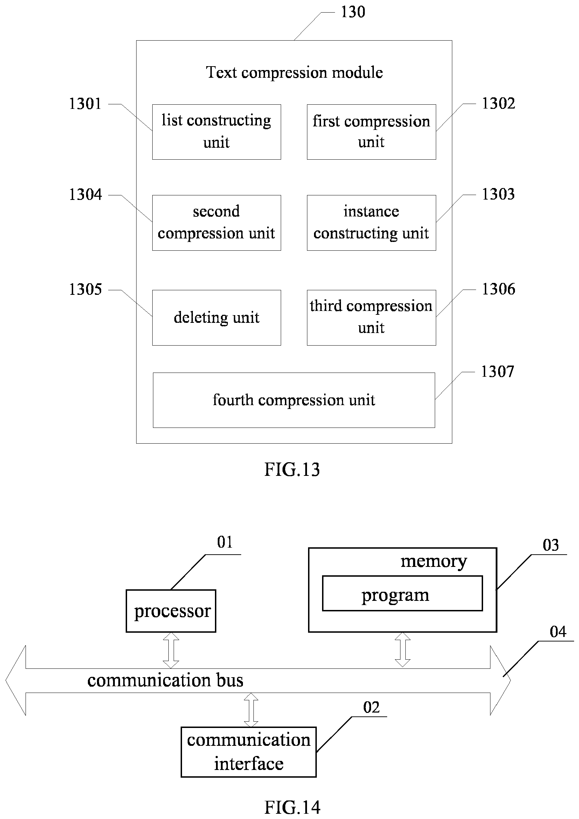

FIG. 13 shows a schematic block diagram of a text compression module in an embodiment of the present disclosure. Referring to FIG. 13, a text compression module may include a list constructing unit 1301 and a first compression unit 1302, wherein:

the list constructing unit 1302 is configured to perform word segmentation processing on texts to be compressed to obtain corresponding words and collect statistics about word length and word frequency of the words obtained after the word segmentation processing to construct a corresponding keyword list. In an embodiment of the present disclosure, the list constructing unit 1302 is configured to divide the texts to be compressed by delimiters to obtain a plurality of corresponding words.

The first compression unit 1302 is configured to compress the texts to be compressed based on the constructed keyword list.

In an embodiment of the present disclosure, the list constructing unit 1301 is configured to collect statistics about word length and word frequency of the words obtained after the word segmentation process based on a preset keyword data structure and a keyword pointer array to construct a corresponding keyword list. Wherein, the keyword data structure comprises: a next member configured to point to a hash singly linked list pointer of a next word with the same hash value; a word member configured to record a corresponding word; a total cnt member configured to record the number of occurrences of the corresponding word; a word_len member configured to record a symbol length of the corresponding word; and an idx_type member configured to record a coded value of the corresponding word.

Specifically, the list constructing unit 1301 is configured to traverse the texts to be compressed to obtain a current word traversed to; calculate the hash value corresponding to the current word; with the calculated hash value as an index, determine whether there is a keyword data structure instance of the current word in the keyword singly linked list pointed to by the corresponding pointer in the keyword pointer array; in response to a determination that the current word exists in the keyword singly linked list pointed to by the corresponding pointer in the keyword pointer array, increase the total_cnt member in the corresponding keyword data structure instance by a preset first numerical value; in response to a determination that the current word does not exist in the keyword singly linked list pointed to by the corresponding pointer in the keyword pointer array, construct the corresponding keyword data structure instance for the current word, and insert the constructed keyword data structure instance into the keyword singly linked list pointed to by the corresponding pointer in the keyword pointer array; obtain the next word as the current word traversed to, and restarting from the step of calculating the hash value of the current word until the traversal of the texts to be compressed is completed.

In an another embodiment of the present disclosure, the first compression unit 1302 is configured to traverse the texts to be compressed to obtain a current word traversed to; combine the current word traversed to with the delimiter at a corresponding position to form a key word of a corresponding type; based on the numerical value of the idx_type member in the keyword data structure instance corresponding to the current word, determine whether the key words of the corresponding type have been allocated an encoding slot; in response to a determination that the key words of the corresponding type has not been allocated an encoding slot and there is an idle encoding slot, allocate an encoding slot for the key words of the corresponding type, and recording the corresponding coded value in the idx_type member of the corresponding keyword data structure instance; in response to a determination that the key words of the corresponding type have been allocated an encoding slot, obtain the coded value recorded in the idx_type member of the corresponding keyword data structure instance; replace the key words of the corresponding type in the texts to be compressed with the coded value recorded in the idx_type member of the corresponding keyword data structure instance; obtain the next word as the current word traversed to, and restarting from the step of combining the current word traversed to with the delimiter at a corresponding position to form a key word of a corresponding type until the traversal of the texts to be compressed is completed, and obtaining a corresponding first compressed text.

In a specific implementation, the text compression module may also include an instance constructing unit 1303, wherein:

The instance constructing unit 1303 is configured to construct a final word data structure instance of the key words of the corresponding type based on a preset final word data structure to record the encoding information of the key words of the corresponding type after allocating an encoding slot for the key words of the corresponding type.

In an embodiment of the present disclosure, the final word data structure comprises: a Str member configured to record the information of the key words of the corresponding type; a Len member configured to record a character length of the key words of the corresponding type; a cnt member configured to record the number of occurrences of the key words of the corresponding type; a node_cnt member configured to record the number of different corresponding types of key word adjacent to the key words of the corresponding type; and a tree member configured to record the information of the adjacency merged red-black tree of the key words of the corresponding type.

In a specific implementation, the text compression module may also include a second compression unit 1304, wherein:

the second compression unit 1304 is configured to perform merged encoding on the large coded word in the first compressed text to obtain a second compressed text after obtaining the first compressed text.

In an embodiment of the present disclosure, the second compression unit 1304 is configured to construct an adjacency merged red-black tree for each of the large coded words in the first compressed text based on a preset merged word data structure; based on the constructed adjacency merged red-black tree, perform merged encoding on the large coded word in the first compressed text.

Specifically, the second compression unit 1304 is configured to scan the first compressed text to obtain the current two adjacent large coded words traversed to; the current two adjacent large coded words include a previous large coded word and a next large coded word after the previous large coded word; determine the corresponding adjacency merged red-black tree by taking a tree member in the final word data structure corresponding to the previous large coded word as a root; query a merged word data structure instance with a key value of the next large coded word in the determined adjacency merged red-black tree; in response to a determination that there is a corresponding merged word data structure instance, increase the count member in the corresponding merged word data structure instance by a preset second value; in response to a determination that there isn't a corresponding merged word data structure instance, construct a corresponding merged word data structure instance, and insert the merged word data structure constructed into the adjacency merged red-black tree of the previous large coded word; and obtain next two adjacent large coded words in the first compressed text, and restart from the step of determining the corresponding adjacency merged red-black tree by taking a tree member in the final word data structure corresponding to the previous large coded word as a root until the traversal of the first compressed text is completed.

Specifically, the second compression unit 1304 is configured to take the first compressed text as a current text to be merged, and traverse the current text to be merged to obtain the current two adjacent large coded words traversed to; query a merged word data structure instance with a key value of the next large coded word in the adjacency merged red-black tree of the previous large coded word of the current two adjacent large coded words; in response to a determination that the numerical value of the count member in the queried merged word data structure instance is greater than or equal to a preset merged threshold, allocate a new merged encoding slot for the current two adjacent large coded words, and constructing a corresponding final word data structure instance; replace the current two adjacent large coded words in the current text to be merged with the coded value of the corresponding merged encoding slot; obtain next two adjacent large coded words in the current text to be merged as the current two adjacent large coded words, and restart from the step of querying a merged word data structure instance with a key value of the next large coded word in the adjacency merged red-black tree of the previous large coded word of the current two adjacent large coded words until the traversal of the current text to be merged is completed, and obtain a next text to be merged; determine whether a preset merging stop condition is met; and in response to a determination that the preset merging stop condition isn't met, take the next text to be merged as the current text to be merged, and restart from the step of traversing the current text to be merged to obtain the current two adjacent large coded words traversed to until the merging stop condition is met, and obtain the second compressed text. The preset merging stop condition is any one of the following: the number of merging rounds is greater than a corresponding round threshold; all of the numerical values of the count member of the merged word data structure instance in the adjacency merged red-black tree of the key words of the corresponding type in the first compressed text are less than the merged threshold; and the encoding slots have been allocated.

In an embodiment of the present disclosure, the key words of the corresponding type comprise: a first type of key word, including the corresponding word and the delimiter after the word; a second type of key word, including the corresponding delimiter and the word after the delimiter; a third type of key word, including the corresponding word and the delimiters before and after the word; and a fourth type of key word, including only the corresponding word.

In a specific implementation, the text compression module may also include a deleting unit 1305, wherein:

The deleting unit 1305 is configured to delete keywords that do not meet the preset encoding conditions from the keyword list before allocating an encoding slot for the key words in the keyword list. In an embodiment of the present disclosure, the encoding conditions comprise: $n \times L > (2+L)$; wherein n indicates the occurrence frequency of the word, L indicates the symbol length of the word.

In a specific implementation, the text compression module may also include a third compression unit 1306, wherein:

the third compression unit 1306 is configured to replace other uncoded symbols in the second compressed text with corresponding ASCII code values to obtain a corresponding third compressed text after obtaining the second compressed text.

In a specific implementation, the text compression module may also include a fourth compression unit 1307, wherein:

the fourth compression unit 1307 is configured to compress the ASCII code values in the third compressed text by a table compression algorithm of Linux kernel symbols after obtaining the third compressed text.

Correspondingly, the embodiments of the present disclosure also provide a chip, the chip comprises the text compression module provided by the embodiments of the present disclosure. Wherein, for the text compression module, please refer to the detailed description in the foregoing part, and details will not be repeated here.

In some embodiments, the embodiments of the present disclosure also provide an electronic device, the electronic device comprises the chip provided by the embodiments of the present disclosure. Wherein, for the text compression module, please refer to the detailed description in the foregoing part, and details will not be repeated here.

An optional hardware structure of the electronic device provided by the embodiment of the present disclosure may be shown in FIG. 14, including: at least one processor 01, at least one communication interface 02, at least one memory 03 and at least one communication bus 04.

In the embodiments of the present disclosure, there are at least one processor 01, communication interface 02, memory 03, and communication bus 04, and processor 01, communication interface 02, and memory 03 complete mutual communication through the communication bus 04.

The communication interface 02 may be an interface of a communication module for network communication, such as an interface of a GSM module.

Processor 01 may be a central processing unit CPU, an application specific integrated circuit (ASIC), or one or more integrated circuits configured to implement the embodiments of the present disclosure.

Memory 03 may include high-speed RAM, and may also include non-volatile memory (NVM), such as at least one disk memory.

Wherein, memory 03 stores one or more computer instructions, the one or more computer instructions are executed by processor 01 to implement the method of configuring assistant patterns provided by the embodiments of the present disclosure.

It should be noted that the electronic device implemented above may also include other components (not shown) that may not be necessary for the content disclosed in the embodiments of the present disclosure; since these other devices may not be necessary for understanding the disclosure of the embodiments of the present disclosure, the embodiments of the present disclosure will not introduce them one by one here.

The embodiments of the present disclosure also provide a storage medium, wherein the storage medium stores at least one or more computer instructions, the one or more computer instructions are executed to implement the static identification area detection method provided by the embodiments of the present disclosure.

The embodiments of the present disclosure described above are combinations of elements and features of the present disclosure. The elements or features may be considered optional unless mentioned otherwise. Each element or feature may be practiced without being combined with other elements or features. In addition, the embodiments of the present disclosure may be configured by combining some elements and/or features. The order of operations described in the embodiments of the present disclosure may be rearranged. Some constructions of any one embodiment may be included in another embodiment and may be replaced with corresponding constructions of another embodiment. It is obvious to those skilled in the art that claims that have no explicit citation relationship with each other among the appended claims may be combined in the embodiments of the present disclosure or may be included as new claims in amendments after filing the present application.

Embodiments of the present disclosure can be realized by various means such as hardware, firmware, software, or a combination thereof. In the hardware configuration mode, the method according to the embodiments of the present disclosure may be implemented by one or more application-specific integrated circuits (ASICs), digital signal processors (DSPs), digital signal processing devices (DSPDs), programmable logic devices (PLDs), field programmable Gate arrays (FPGA), processors, controllers, micro-controllers, microprocessors, etc. to achieve.

In a firmware or software configuration, the embodiments of the present disclosure can be implemented in the form of modules, procedures, functions, and the like. The software codes may be stored in memory units and executed by processors. The memory unit is located inside or outside the processor, and can transmit data to and receive data from the processor via various known means.

The above description of the disclosed embodiments is provided to enable any person skilled in the art to make or use the embodiments of the present disclosure. Various modifications to these embodiments will be readily apparent to those skilled in the art, and the general principles defined herein may be implemented in other embodiments without departing from the spirit or scope of the disclosure. Therefore, the present disclosure will not be limited to the embodiments shown herein but is to be accorded the widest scope consistent with the principles and novel features disclosed herein.

Correspondingly, the embodiments of the present disclosure also provide a storage medium, wherein the storage medium stores at least one or more computer instructions, and one or more computer instructions are executed to implement the text compression method provided by the embodiments of the present disclosure. Wherein, for the text compression method, please refer to the foregoing detailed introduction, and details will not be repeated here.

Although the embodiments of the present disclosure are disclosed as above, the present disclosure is not limited therein. Any person skilled in the art may make various changes and modifications without departing from the spirit and scope of the present disclosure, and therefore the scope of protection of the present disclosure shall be subject to the scope defined by the claims.

## Claims

1. A text compression method, comprising:

   performing word segmentation processing on texts to be compressed, and collecting statistics about word length and word frequency of the words obtained after the word segmentation processing to construct a corresponding keyword list; and

   compressing the texts to be compressed based on the constructed keyword list.

2. The text compression method of claim 1, wherein performing word segmentation processing on texts to be compressed comprises:
   dividing the texts to be compressed by delimiters to obtain a plurality of corresponding words.

3. The text compression method of claim 1, wherein the collecting statistics about word length and word frequency of the words obtained after the word segmentation processing to construct a corresponding keyword list comprises:
   based on a preset keyword data structure and a keyword pointer array, collecting statistics about word length and word frequency of the words obtained after the word segmentation process to construct a corresponding keyword list.

4. The text compression method of claim 3, wherein the keyword data structure comprises:

   a next member configured to point to a hash singly linked list pointer of a next word with the same hash value;

   a word member configured to record a corresponding word;

   a total cnt member configured to record the number of occurrences of the corresponding word;

   a word len member configured to record a symbol length of the corresponding word; and

   an idx _type member configured to record a coded value of the corresponding word.

5. The text compression method of claim 4, wherein performing word segmentation processing on texts to be compressed, and collecting statistics about word length and word frequency of the words obtained after the word segmentation processing to construct a corresponding keyword list comprises:

   traversing the divided words in the texts to be compressed to obtain a current word traversed to;

   calculating the hash value corresponding to the current word;

   with the calculated hash value as an index, determining whether there is a keyword data structure instance of the current word in the keyword singly linked list pointed to by the corresponding pointer in the keyword pointer array;

   in response to a determination that the current word exists in the keyword singly linked list pointed to by the corresponding pointer in the keyword pointer array, increasing the total_cnt member in the corresponding keyword data structure instance by a preset first numerical value;

   in response to a determination that the current word does not exist in the keyword singly linked list pointed to by the corresponding pointer in the keyword pointer array, constructing the corresponding keyword data structure instance for the current word, and inserting the constructed keyword data structure instance into the keyword singly linked list pointed to by the corresponding pointer in the keyword pointer array; and

   obtaining the next word as the current word traversed to, and restarting from the step of calculating the hash value of the current word until the traversal of the texts to be compressed is completed.

6. The text compression method of claim 5, wherein compressing the texts to be compressed based on the constructed keyword list comprises:

   traversing the texts to be compressed to obtain a current word traversed to;

   combining the current word traversed to with the delimiter at a corresponding position to form a key word of a corresponding type;

   based on the numerical value of the idx_type member in the keyword data structure instance corresponding to the current word, determining whether the key words of the corresponding type have been allocated an encoding slot;

   in response to a determination that the key words of the corresponding type have not been allocated an encoding slot and there is an idle encoding slot, allocating an encoding slot for the key words of the corresponding type, and recording the corresponding coded value in the idx_type member of the corresponding keyword data structure instance;

   in response to a determination that the key words of the corresponding type have been allocated an encoding slot, obtaining the coded value recorded in the idx_type member of the corresponding keyword data structure instance;

   replacing the key words of the corresponding type in the texts to be compressed with the coded value recorded in the idx_type member of the corresponding keyword data structure instance; and

obtaining the next word as the current word traversed to, and restarting from the step of combining the current word traversed to with the delimiter at a corresponding position to form the key words of the corresponding type until the traversal of the texts to be compressed is completed, and obtaining a corresponding first compressed text.

7. The text compression method of claim 6, wherein after allocating an encoding slot for the key words of the corresponding type, further comprising:
based on a preset final word data structure, constructing a final word data structure instance of the key words of the corresponding type to record the encoding information of the key words of the corresponding type.

8. The text compression method of claim 7, wherein the final word data structure comprises:

a Str member configured to record the information of the key words of the corresponding type;
a Len member configured to record a character length of the key words of the corresponding type;
a cnt member configured to record the number of occurrences of the key words of the corresponding type;
a node_cnt member configured to record the number of different corresponding types of key word adjacent to the key words of the corresponding type; and
a tree member configured to record the information of the adjacency merged red-black tree of the key words of the corresponding type.

9. The text compression method of claim 8, wherein taking the coded value of the key words of the corresponding type in the first compressed text as a large coded word, after obtaining the first compressed text, further comprising:
performing merged encoding on the large coded word in the first compressed text to obtain a second compressed text.

10. The text compression method of claim 9, wherein performing merged encoding on the large coded word in the first compressed text comprises:

based on a preset merged word data structure, constructing an adjacency merged red-black tree for each of the large coded words in the first compressed text; and
based on the constructed adjacency merged red-black tree, performing merged encoding on the large coded word in the first compressed text.

11. The text compression method of claim 10, wherein the merged word data structure comprises:

an entry member configured to represent a root node of the adjacency merged red-black tree;
a code member configured to record the coded value of the key word of the corresponding type adjacent to the root node; and
a count member configured to record the number of occurrences of the key words of the corresponding type adjacent to the root node.

12. The text compression method of claim 11, wherein based on a preset merged word data structure, constructing an adjacency merged red-black tree for each of the large coded words in the first compressed text comprises:

scanning the first compressed text to obtain current two adjacent large coded words traversed to; the current two adjacent large coded words include a previous large coded word and a next large coded word after the previous large coded word;
determining the corresponding adjacency merged red-black tree by taking a tree member in the final word data structure corresponding to the previous large coded word as a root;
querying a merged word data structure instance with a key value of the next large coded word in the determined adjacency merged red-black tree;
in response to a determination that there is a corresponding merged word data structure instance, increasing the count member in the corresponding merged word data structure instance by a preset second value;
in response to a determination that there isn't a corresponding merged word data structure instance, constructing a corresponding merged word data structure instance, and insert the merged word data structure constructed into the adjacency merged red-black tree of the previous large coded word; and
obtaining next two adjacent large coded words in the first compressed text, and restarting from the step of determining the corresponding adjacency merged red-black tree by taking a tree member in the final word data structure corresponding to the previous large coded word as a root until the traversal of the first compressed text is completed.

13. The text compression method of claim 12, wherein performing merged encoding on the large coded word in the first compressed text comprises:

taking the first compressed text as a current text to be merged, and traversing the current text to be merged to obtain the current two adjacent large coded words traversed to;
querying a merged word data structure instance with a key value of the next large coded word in the adjacency merged red-black tree of the previous large coded word of the current two adjacent large coded words;
in response to a determination that the numerical value of the count member in the queried merged word data structure instance is greater than or equal to a preset merged threshold, allocating a new merged encoding slot for the current two adjacent large coded words, and constructing a corresponding final word data structure instance;
replacing the current two adjacent large coded words in the current text to be merged with the coded value of the corresponding merged encoding slot;
obtaining the next two adjacent large coded words in the current text to be merged as the current two adjacent large coded words, and restarting from the step of querying a merged word data structure instance with a key value of the next large coded word in the adjacency merged red-black tree of the previous large coded word of the current two adjacent large coded words until the traversal of the current text to be merged is completed, and obtaining a next text to be merged;
determining whether a preset merging stop condition is met; and
in response to a determination that the preset merging stop condition isn't met, taking the next text to be merged as the current text to be merged, and restarting from the step of traversing the current text to be merged to obtain the current two adjacent large coded words traversed to until the preset merging stop condition is met, and obtaining the second compressed text.

14. The text compression method of claim 13, wherein the preset merging stop condition is any one of the following:

the number of merging rounds is greater than a corresponding round threshold;
all of the numerical values of the count member of the merged word data structure instance in the adjacency merged red-black tree of the key words of the corresponding type in the first compressed text are less than the merged threshold; and

the encoding slots have been allocated.

15. The text compression method based on any one of claims 6-14, wherein the key words of the corresponding type comprise:

a first type of key word, including the corresponding word and the delimiter after the word;
a second type of key word, including the corresponding delimiter and the word after the delimiter;
a third type of key word, including the corresponding word and the delimiters before and after the word; and
a fourth type of key word, including only the corresponding word.

16. The text compression method of claim 15, wherein before allocating an encoding slot for the key words in the keyword list, further comprising:
deleting keywords that do not meet the preset encoding conditions from the keyword list.

17. The text compression method of claim 16, wherein the encoding conditions comprise:

$$n \times \mathrm{L} > (2 + \mathrm{L}) ;$$

Wherein, n indicates the occurrence frequency of the word, L indicates the symbol length of the word.

18. The text compression method of claim 17, wherein after obtaining the second compressed text, further comprising:
replacing other uncoded symbols in the second compressed text with corresponding ASCII code values to obtain a corresponding third compressed text.

19. The text compression method of claim 18, wherein after obtaining the third compressed text, further comprising:
compressing the ASCII code values in the third compressed text by a table compression algorithm of Linux kernel symbols.

20. A text compression module, comprising:

a list constructing unit configured to perform word segmentation processing on texts to be compressed, and collect statistics about word length and word frequency of the words obtained after the word segmentation processing to construct a corresponding keyword list; and
a first compression unit configured to compress the texts to be compressed based on the constructed keyword list.

**21.** The text compression module of claim 20, wherein the list constructing unit is configured to divide the texts to be compressed by delimiters to obtain a plurality of corresponding words.

**22.** The text compression module of claim 20, wherein the list constructing unit is configured to collect statistics about word length and word frequency of the words obtained after the word segmentation processing based on a preset keyword data structure and a keyword pointer array to construct a corresponding keyword list.

**23.** The text compression module of claim 21, wherein the keyword data structure comprises:

a next member configured to point to a hash singly linked list pointer of a next word with the same hash value;
a word member configured to record a corresponding word;
a total cnt member configured to record the number of occurrences of the corresponding word;
a word len member configured to record a symbol length of the corresponding word; and
an idx_type member configured to record a coded value of the corresponding word.

**24.** The text compression module of claim 23, wherein the list constructing unit is configured to traverse the texts to be compressed to obtain a current word traversed to; calculate the hash value corresponding to the current word; with the calculated hash value as an index, determine whether there is a keyword data structure instance of the current word in the keyword singly linked list pointed to by the corresponding pointer in the keyword pointer array; in response to a determination that the current word exists in the keyword singly linked list pointed to by the corresponding pointer in the keyword pointer array, increase the total cnt member in the corresponding keyword data structure instance by a preset first numerical value; in response to a determination that the current word does not exist in the keyword singly linked list pointed to by the corresponding pointer in the keyword pointer array, construct the corresponding keyword data structure instance for the current word, and insert the constructed keyword data structure instance into the keyword singly linked list pointed to by the corresponding pointer in the keyword pointer array; obtain the next word as the current word traversed to, and restarting from the step of calculating the hash value of the current word until the traversal of the texts to be compressed is completed.

**25.** The text compression module of claim 24, wherein the first compression unit is configured to traverse the texts to be compressed to obtain a current word traversed to; combine the current word traversed to with the delimiter at a corresponding position to form a key word of a corresponding type; based on the numerical value of the idx_type member in the keyword data structure instance corresponding to the current word, determine whether the key words of the corresponding type have been allocated an encoding slot; in response to a determination that the key words of the corresponding type has not been allocated an encoding slot and there is an idle encoding slot, allocate an encoding slot for the key words of the corresponding type, and recording the corresponding coded value in the idx_type member of the corresponding keyword data structure instance; in response to a determination that the key words of the corresponding type have been allocated an encoding slot, obtain the coded value recorded in the idx_type member of the corresponding keyword data structure instance; replace the key words of the corresponding type in the texts to be compressed with the coded value recorded in the idx_type member of the corresponding keyword data structure instance; obtain the next word as the current word traversed to, and restarting from the step of combining the current word traversed to with the delimiter at a corresponding position to form a key word of a corresponding type until the traversal of the texts to be compressed is completed, and obtaining a corresponding first compressed text.

**26.** The text compression module of claim 25, wherein further comprising:
an instance constructing unit configured to construct a final word data structure instance of the key words of the corresponding type based on a preset final word data structure to record the encoding information of the key words of the corresponding type after allocating an encoding slot for the key words of the corresponding type.

**27.** The text compression module of claim 26, wherein the final word data structure comprises:

a Str member configured to record the information of the key words of the corresponding type;
a Len member configured to record a character length of the key words of the corresponding type;
a cnt member configured to record the number of occurrences of the key words of the corresponding type;
a node_cnt member configured to record the number of different corresponding types of key word adjacent to the key words of the corresponding type; and
a tree member configured to record the information of the adjacency merged red-black tree of the key words of the corresponding type.

28. The text compression module of claim 27, wherein further comprising:
a second compression unit configured to configure the coded value of the key words of the corresponding type in the first compressed text as a large coded word, and perform merged encoding on the large coded word in the first compressed text to obtain a second compressed text after obtaining the first compressed text.

29. The text compression module of claim 28, wherein the second compression unit is configured to construct an adjacency merged red-black tree for each of the large coded words in the first compressed text based on a preset merged word data structure; based on the constructed adjacency merged red-black tree, perform merged encoding on the large coded word in the first compressed text.

30. The text compression module of claim 29, wherein the merged word data structure comprises:

an entry member configured to represent a root node of the adjacency merged red-black tree; a code member configured to record the coded value of the key word of the corresponding type adjacent to the root node; and a count member configured to record the number of occurrences of the key words of the corresponding type adjacent to the root node.

31. The text compression module of claim 30, wherein the second compression unit is configured to scan the first compressed text to obtain current two adjacent large coded words traversed to; the current two adjacent large coded words include a previous large coded word and a next large coded word after the previous large coded word; determine the corresponding adjacency merged red-black tree by taking a tree member in the final word data structure corresponding to the previous large coded word as a root; query a merged word data structure instance with a key value of the next large coded word in the determined adjacency merged red-black tree; in response to a determination that there is a corresponding merged word data structure instance, increase the count member in the corresponding merged word data structure instance by a preset second value; in response to a determination that there isn't a corresponding merged word data structure instance, construct a corresponding merged word data structure instance, and insert the merged word data structure constructed into the adjacency merged red-black tree of the previous large coded word; and obtain next two adjacent large coded words in the first compressed text, and restart from the step of determining the corresponding adjacency merged red-black tree by taking a tree member in the final word data structure corresponding to the previous large coded word as a root until the traversal of the first compressed text is completed.

32. The text compression module of claim 31, wherein the second compression unit is configured to take the first compressed text as a current text to be merged, and traverse the current text to be merged to obtain the current two adjacent large coded words traversed to; query a merged word data structure instance with a key value of the next large coded word in the adjacency merged red-black tree of the previous large coded word of the current two adjacent large coded words; in response to a determination that the numerical value of the count member in the queried merged word data structure instance is greater than or equal to a preset merged threshold, allocate a new merged encoding slot for the current two adjacent large coded words, and constructing a corresponding final word data structure instance; replace the current two adjacent large coded words in the current text to be merged with the coded value of the corresponding merged encoding slot; obtain next two adjacent large coded words in the current text to be merged as the current two adjacent large coded words, and restart from the step of querying a merged word data structure instance with a key value of the next large coded word in the adjacency merged red-black tree of the previous large coded word of the current two adjacent large coded words until the traversal of the current text to be merged is completed, and obtain a next text to be merged; determine whether a preset merging stop condition is met; and in response to a determination that the preset merging stop condition isn't met, take the next text to be merged as the current text to be merged, and restart from the step of traversing the current text to be merged to obtain the current two adjacent large coded words traversed to until the preset merging stop condition is met, and obtain the second compressed text.

33. The text compression module of claim 32, wherein the preset merging stop condition is any one of the following:

the number of merging rounds is greater than a corresponding round threshold; all of the numerical values of the count member of the merged word data structure instance in the adjacency merged red-black tree of the key words of the corresponding type in the first compressed text are less than the merged threshold; and the encoding slots have been allocated.

**34.** The text compression module based on any one of claims 25-33, wherein the key words of the corresponding type comprise:

a first type of key word, including the corresponding word and the delimiter after the word;
a second type of key word, including the corresponding delimiter and the word after the delimiter;
a third type of key word, including the corresponding word and the delimiters before and after the word; and
a fourth type of key word, including only the corresponding word.

**35.** The text compression module of claim 34, wherein further comprising:
a deleting unit configured to delete keywords that do not meet the preset encoding conditions from the keyword list before allocating an encoding slot for the key words in the keyword list.

**36.** The text compression module of claim 35, wherein the encoding conditions comprise:

$$n \times L > (2+L)$$ ;

Wherein, n indicates the occurrence frequency of the word, L indicates the symbol length of the word.

**37.** The text compression module of claim 32, wherein further comprising:
a third compression unit configured to replace other uncoded symbols in the second compressed text with corresponding ASCII code values to obtain a corresponding third compressed text after obtaining the second compressed text.

**38.** The text compression module of claim 37, wherein further comprising:
a fourth compression unit configured to compress the ASCII code values in the third compressed text by a table compression algorithm of Linux kernel symbols after obtaining the third compressed text.

**39.** A chip, comprising the text compression module based on any one of claims 20-38.

**40.** An electronic device, comprising the chip of claim 39.

**41.** A storage medium, wherein the storage medium stores at least one or more computer instructions, one or more computer instructions are executed to implement the text compression method based on any one of claims 1-19.

performing word segmentation processing on texts to be compressed, and collecting statistics about word length and word frequency of the words obtained after the word segmentation processing to construct a corresponding keyword list — S110

compressing the texts to be compressed based on the constructed keyword list — S120

performing merged encoding on the large coded word in the first compressed text to obtain a second compressed text — S130

replacing other uncoded symbols in the second compressed text with corresponding ASCII code values to obtain a corresponding third compressed text — S140

compressing the ASCII code values in the third compressed text by a table compression algorithm of Linux kernel symbols — S150

FIG.1

Start

traversing the texts to be compressed to obtain a current word traversed to — S1101

calculating the hash value corresponding to the current word — S1102

determining whether there is a keyword data structure instAnce of the current word in the keyword singly linked list pointed to by the corresponding pointer in the keyword pointer array? — S1103

yes | no

increasing the total_cnt member in the corresponding keyword data structure instance by a preset first numerical value — S1104

constructing the corresponding keyword data structure instance for the current word, and inserting the constructed keyword data structure instance into the keyword singly linked list pointed to by the corresponding pointer in the keyword pointer array — S1105

Determining whether the traversal of the Texts to be compressed is completed? — S1106

no

obtaining the next word as the current word traversed to — S1107

yes

end

FIG.2

key_words

| |
|---|
| 0 |
| 1 |
| 2 |
| ... |
| 357 |
| ... |
| 496 |
| ... |
| 4095 |

override

find → event → notifier

show → reboot

FIG.3

```
                          start

   traversing the texts to be compressed to obtain a current word        S1201
                        traversed to

            calculating the hash value of the current word               S1202

                  Determining whether there is a
   no         keyword data structure instance of the current word in     S1203
              the keyword singly linked list pointed to by the
                      corresponding pointer in the
                         keyword pointer array

                              yes

                    Determining whether the key                          S1204
   yes       words of the corresponding type have been allocated an
                          encoding slot

                              no

       allocating an encoding slot for the key words of the corresponding  S1205
       type, and recording the corresponding coded value in the idx_type
       member of the corresponding keyword data structure instance, and
       constructing a final word data structure instance for the key words
                        of the corresponding type

       obtaining the coded value recorded in the idx_type member of the    S1206
       corresponding keyword data structure instance, and replacing the
       key words of the corresponding type in the texts to be compressed
       with the coded value recorded in the idx_type member of the
                  corresponding keyword data structure instance

                    Determining whether the traversal                    S1207
   no            of the texts to be compressed is completed?

   obtaining the next    S1208               yes
   word in the texts to
   be compressed as the                      end
   current word
   traversed to
```

FIG.4

start

scanning the first compressed text to obtain the current two adjacent large coded words traversed to ⟋ S1301

determining the corresponding adjacency merged red-black tree by taking a tree member in the final word data structure corresponding to the previous large coded word as a root ⟋ S1302

Querying a merged word data structure instance with a key value of the next large coded word in the determined adjacency merged red-black tree ⟋ S1303

yes                    no

increasing the count member in the corresponding merged word data structure instance by a preset second numerical value ⟋ S1304

constructing a corresponding merged word data structure instance, and insert the merged word data structure constructed into the adjacency merged red-black tree of the previous large coded word ⟋ S1305

Determining whether the traversal of the texts to be compressed is completed? ⟋ S1306

no

obtaining next two adjacent large coded words in the first compressed text as the current two adjacent large coded words traversed to ⟋ S1307

yes

end

FIG.5

FIG.6

start

taking the first compressed text as a current text to be merged, and traversing the current text to be merged to obtain the current two adjacent large coded words traversed to — S1311

querying a merged word data structure instance with a key value of the next large coded word in the adjacency merged red-black tree of the previous large coded word of the current two adjacent large coded words — S1312

Determining whether the numerical value of the count member in the queried merged word data structure instance is greater than or equal to a preset merged threshold — S1313

no

yes

allocating a new merged encoding slot for the current two adjacent large coded words, and constructing a corresponding final word data structure instance — S1314

replacing the current two adjacent large coded words in the current text to be merged with the coded value of the corresponding merged encoding slot — S1315

Determining whether the traversal of current texts to be merged is completed — S1316

no

S1317

obtaining the next two adjacent large coded words in the current text to be merged as the current two adjacent large coded words

yes

Determining whether a preset merging stop condition is met — S1318

no

yes

S1319

taking the next text to be merged as the current text to be merged

end

FIG.7

constructing a two-dimensional array token_profit and counting the number of occurrences of uncoded characters in the third compressed text ⌐ S151

construct a two-dimensional array best_table and a two-dimensional length array best_table_len ⌐ S152

in the two-dimensional array best_table, allocating corresponding encoding slots for each uncoded single character appearing in the third compressed text ⌐ S153

in the two-dimensional array best_table, allocating corresponding encoding slots for consecutive characters that appear multiple times in the third compressed text ⌐ S154

FIG.8

start

traversing the third compressed text to obtain the current two adjacent characters traversed to

S1511

aking the ACSII code value of the current two adjacent characters traversed to as the row index and the column index respectively, and increasing the number of occurrences of the corresponding members in the two-dimensional array token _ profit by a preset third value

S1512

Determining whether the traversal of the texts to be compressed is completed?

S1513

no

S1514

obtaining the next two adjacent characters as the current two adjacent characters traversed to

yes

end

FIG.9

| | 0... | 101 e | 102 f | 103 g | 104 h | 105 i | 106 j | 107 k | 108 l | 109 m | 110 n | ...255 |
|---|---|---|---|---|---|---|---|---|---|---|---|---|
| 101 e | | | 201 | 153 | | | | | 83 | 347 | 135 | |
| 102 f | | 85 | | | | | | | | | | |
| 103 g | | 13 | | | 4 | | | | | | | |
| 104 h | | | | 7 | | | | | | | | |
| 105 i | | | 54 | | | | | 47 | 217 | 745 | 103 | |
| 106 j | | | | | | | | | | | | |
| 107 k | | | | | | 21 | | | | | | |
| 108 l | | | | | | 94 | | | | | | |
| 109 m | | | | | | | | 3 | | | | |
| 110 n | | 436 | | | | | | | | | | |
| ...255 | | | | | | | | | | | | |

FIG.10

| 0 | ··· | 48 | ··· | 57 | ··· | 65 | ··· | 90 | ··· | 95 | ··· | 97 | ··· | 122 | ··· | 255 |
|---|---|---|---|---|---|---|---|---|---|---|---|---|---|---|---|---|
| | | 0 ··· 9 | | A ··· Z | | | | | | – | | a ··· z | | | | |

Encoded slots allocated

Encoded slots unallocated

FIG.11

start

S1541

obtaining the maximum optimized value from the two-dimensional array token_profit

S1542

determining whether the obtained maximum optimized value is greater than the preset optimized threshold

no

yes

S1543

setting Ca and Cb respectively as two consecutive characters corresponding to the row index and column index of the maximum optimized value

S1544

traversing the two-dimensional array best_table in order from back to front to obtain the current idle encoding slot traversed to

S1545

in the two-dimensional array best_table_len, marking the current free encoding slot as allocated, and setting the corresponding members in the two-dimensional array best_table as two consecutive characters corresponding to Ca and Cb

S1546

replacing the two consecutive characters corresponding to Ca and Cb in the third compressed text with the coded value corresponding to the currently traversed idle encoding slot

S1547

setting the optimized values of the corresponding members of Ca and Cb in the two-dimensional array token_profit as preset values, to serve as compression marks corresponding to two consecutive characters of Ca and Cb

S1548

yes

Determining whether there are idle encoding slots in the two-dimensional array best_table

no

end

FIG.12

130

Text compression module

1301 — list constructing unit

1302 — first compression unit

1304 — second compression unit

1303 — instance constructing unit

1305 — deleting unit

1306 — third compression unit

1307 — fourth compression unit

FIG.13

01 processor

03 memory
program

04 communication bus

02 communication interface

FIG.14

## INTERNATIONAL SEARCH REPORT

| International application No. |
|---|
| **PCT/CN2021/125766** |

**A. CLASSIFICATION OF SUBJECT MATTER**

G06F 40/146(2020.01)i

According to International Patent Classification (IPC) or to both national classification and IPC

**B. FIELDS SEARCHED**

Minimum documentation searched (classification system followed by classification symbols)

G06F

Documentation searched other than minimum documentation to the extent that such documents are included in the fields searched

Electronic data base consulted during the international search (name of data base and, where practicable, search terms used)

USTXT; DWPI; SIPOABS; CNKI; CNABS; CNTXT: 文本压缩, 分词, 词频, 词长, 哈希值, 指针text compress+, word segmentation, word frequency, word length, hash value, pointer

**C. DOCUMENTS CONSIDERED TO BE RELEVANT**

| Category* | Citation of document, with indication, where appropriate, of the relevant passages | Relevant to claim No. |
|---|---|---|
| Y | CN 106202172 A (AGRICULTURAL BANK OF CHINA) 07 December 2016 (2016-12-07) description paragraphs 2-133 | 1-4, 20-23, 39-41 |
| Y | CN 102567322 A (PEKING UNIVERSITY et al.) 11 July 2012 (2012-07-11) description, paragraphs 4-118 | 1-4, 20-23, 39-41 |
| A | US 2006158357 A1 (VISTEON GLOBAL TECHNOLOGIES, INC.) 20 July 2006 (2006-07-20) entire document | 1-41 |
| A | US 7026962 B1 (MOTOROLA, INC.) 11 April 2006 (2006-04-11) entire document | 1-41 |

☐ Further documents are listed in the continuation of Box C.   ☑ See patent family annex.

| * Special categories of cited documents: | |
|---|---|
| "A" document defining the general state of the art which is not considered to be of particular relevance | "T" later document published after the international filing date or priority date and not in conflict with the application but cited to understand the principle or theory underlying the invention |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | |
| "O" document referring to an oral disclosure, use, exhibition or other means | "Y" document of particular relevance; the claimed invention cannot be considered to involve an inventive step when the document is combined with one or more other such documents, such combination being obvious to a person skilled in the art |
| "P" document published prior to the international filing date but later than the priority date claimed | "&" document member of the same patent family |

| Date of the actual completion of the international search | Date of mailing of the international search report |
|---|---|
| **24 November 2021** | **25 January 2022** |

| Name and mailing address of the ISA/CN | Authorized officer |
|---|---|
| **China National Intellectual Property Administration (ISA/ CN)** **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**
Information on patent family members

| International application No. |
| --- |
| **PCT/CN2021/125766** |

| Patent document cited in search report | | | Publication date (day/month/year) | Patent family member(s) | | | Publication date (day/month/year) |
| --- | --- | --- | --- | --- | --- | --- | --- |
| CN | 106202172 | A | 07 December 2016 | CN | 106202172 | B | 30 July 2019 |
| CN | 102567322 | A | 11 July 2012 | CN | 102567322 | B | 01 April 2015 |
| US | 2006158357 | A1 | 20 July 2006 | DE | 102006002832 | B4 | 21 January 2010 |
| | | | | DE | 102006002832 | A1 | 27 July 2006 |
| US | 7026962 | B1 | 11 April 2006 | None | | | |

Form PCT/ISA/210 (patent family annex) (January 2015)